# EUROPÄISCHE PATENTANMELDUNG

(11) **EP 0 984 674 A1**
(43) Veröffentlichungstag der Anmeldung: **08.03.2000**
(21) Anmeldenummer: 99115771.0
(22) Anmeldetag: 10.08.1999
(51) Int. Cl.: H05K 9/00, H02B 1/44

(54) **Baugruppe mit frontseitiger Abdeckung**

(30) Priorität: 31.08.1998 DE 29815629 U
(71) Anmelder: SIEMENS AKTIENGESELLSCHAFT, 80333 München (DE)
(72) Erfinder: Schwind, Stefan, 82140 Olching (DE); Niggl, Heinz-Jürgen, 82343 Pöcking (DE)

(57) **Zusammenfassung**

Die vorliegende Erfindung betrifft eine Baugruppe mit frontseitiger Abdeckung. An den vorderen Kanten der Seitenteile des Baugruppengehäuses sind außen erste Kontaktfedern (3) angeordnet, deren Federkräfte zur Seite wirken, an den vorderen Querholmen des Baugruppengehäuses sind außen zweite Kontaktfedern (4) angeodnet, deren Federkräfte nach vorne wirken, wobei an der Unterseite des Baugruppengehäuses eine nach außen ragende Rastfeder (5) und an der Oberseite des Baugruppengehäuses eine Erhebung (6) angeordnet ist, und die Abdeckung (2) einen C-förmigen Längsschnitt und einen U-förmigen Querschnitt aufweist.

## Beschreibung

Die vorliegende Erfindung betrifft eine Baugruppe mit einer frontseitigen Abdeckung.

Bei bekannten Baugruppen mit einer frontseitigen Abdeckung ist bei der Montage bzw. bei der Demontage der Schirmabdekkung eine besondere Aufmerksamkeit bzw. ein besonderer Aufwand erforderlich. So müssen z. B. gleichzeitig Rasthaken geöffnet und die Abdeckung nach vorne gezogen werden oder die Baugruppe verfügt über zusätzliche Federelemente zur Entriegelung der Abdeckung, bzw. es werden zur Verriegelung der Abdeckung Schrauben verwendet.

Aufgabe der vorliegenden Erfindung ist es, eine einfache und sichere Montage und Demontage einer frontseitigen Abdeckung für ein geschirmtes Baugruppengehäuse anzugeben.

Zur Lösung dieser Aufgabe ist die erfindungsgemäße Baugruppe dadurch gekennzeichnet, daß außen an den vorderen Kanten der Seitenteile des Baugruppengehäuses erste Kontaktfedern angeordnet sind, deren Federkräfte zur Seite wirken, daß außen an den vorderen Querholmen des Baugruppengehäuses zweite Kontaktfedern angeordnet sind, deren Federkräfte nach vorne wirken, daß an der Unterseite des Baugruppengehäuses eine nach außen ragende Rastfeder und an der Oberseite des Baugruppengehäuses eine Erhebung angeordnet ist, und daß die Abdeckung einen C-förmigen Längsschnitt und einen U-förmigen Querschnitt aufweist.

Bei der erfindungsgemäßen Baugruppe werden die Kontaktfedern, welche zur Schirmung der Baugruppe dienen, gleichzeitig dazu verwendet eine Kraft auf die Abdeckung auszuüben, so daß bei der Entriegelung der Rastfeder die Abdeckung lediglich durch die Federkräfte der Kontaktfedern nach vorne gedrückt wird und anschließend lediglich von der Baugruppe abgehoben werden muß.

Die vorliegende Erfindung wird nachfolgend anhand der Beschreibung eines in der Zeichnung dargestellten Ausführungsbeispiels näher beschrieben.

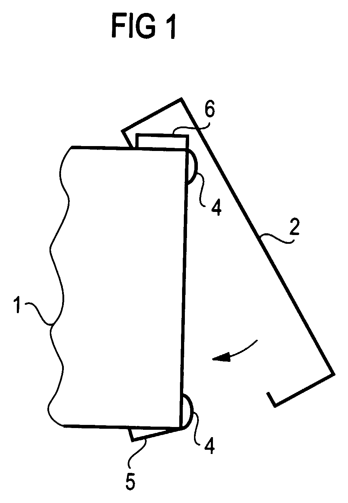

Es zeigen
Figur 1 einen schematischen Querschnitt durch eine erfindungsgemäße Baugruppe mit teilweise abgehobener Abdeckung,

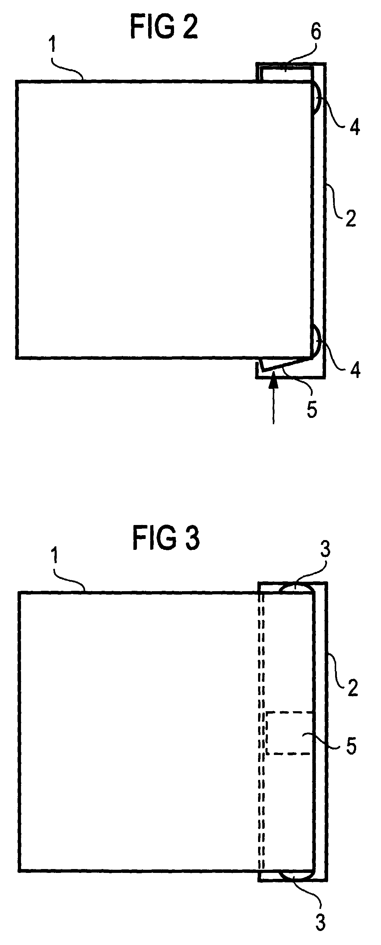

Figur 2 einen Querschnitt durch die in Figur 1 gezeigte Baugruppe mit aufgerasteter Abdeckung, und
Figur 3 eine Draufsicht auf die in Figur 1 dargestellte Baugruppe.

Die erfindungsgemäße Baugruppe besteht im wesentlichen aus dem Baugruppengehäuse 1 und der Abdeckung 2.

Aus Schirmungsgründen sind außen an den vorderen Kanten der Seitenteile des Baugruppengehäuses 1 erste Kontaktfedern 3 angeordnet, deren Federkräfte zur Seite wirken. Weiterhin sind außen an den vorderen Querholmen des Baugruppengehäuses 1 zweite Kontaktfedern 4 angeordnet, deren Federkräfte nach vorne wirken. Diese ersten Kontaktfedern 3 und zweiten Kontaktfedern 4 dienen in erster Linie zur elektromagnetischen Abschirmung des Baugruppengehäuses 1.

Auf der Unterseite des Baugruppengehäuses 1 befindet sich eine nach außen, d. h. nach unten ragende Rastfeder 5 und auf der Oberseite des Baugruppengehäuses 1 ist im vorderen Bereich eine Erhebung 6, die beliebig gestaltet sein kann, angeordnet.

Die Abdeckung 2 weist, wie aus den Figuren zu ersehen ist, einen C-förmigen vertikalen Längsschnitt und einen U-förmigen horizontalen Querschnitt auf.

Zur Montage wird die Abdeckung 2 zuerst hinter der Erhebung 6 auf der Oberseite des Baugruppengehäuses 1 eingehängt. Dabei ist bei der Montage der Abdeckung 2 das Augenmerk nur auf diese obere Kante des Baugruppengehäuses 1 erforderlich. Danach wird die Abdeckung 2 nach unten zum Baugruppengehäuse 1 hin geschwenkt und rastet mit ihrem unteren freien Schenkel hinter der Rastfeder 5 ein. Dies geschieht gegen den Kontaktdruck der unteren zweiten Kontaktfedern 4, so daß die Abdekkung sowohl am oberen als auch am unteren Holm wackelfrei aufliegt.

Die Demontage der Abdeckung 2 erfolgt ebenfalls in einfachen aufeinanderfolgenden Schritten. Zuerst wird mittels eines einfachen Werkzeugs, z. B. eines Schraubendrehers, die Rastfeder 5 durch eine Öffnung in der Abdeckung 2 zur Entriegelung der Abdeckung in Richtung auf das Baugruppengehäuse 1 hin eingedrückt. Dann drückt die Federkraft der zweiten Kontaktfedern 4 am unteren Querholm die Abdeckung 2 einige Millimeter nach vorne und verhindert damit ein ungewolltes Wiedereinrasten der Abdeckung nachdem die Rastfeder 5 wieder entspannt ist. Dann kann die Abdeckung 2 einfach nach oben hin abgenommen werden.

## Patentansprüche

1. Baugruppe mit frontseitiger Abdeckung,
**dadurch gekennzeichnet,**
daß außen an den vorderen Kanten der Seitenteile des Baugruppengehäuses erste Kontaktfedern (3) angeordnet sind, deren Federkräfte zur Seite wirken,
daß außen an den vorderen Querholmen des Baugruppengehäuses (1) zweite Kontaktfedern (4) angeordnet sind, deren Federkräfte nach vorne wirken,
daß an der Unterseite des Baugruppengehäuses eine nach außen ragende Rastfeder (5) und an der Oberseite des Baugruppengehäuses eine Erhebung (6) angeordnet ist,
daß die Abdeckung einen C-förmigen Längsschnitt und einen U-förmigen Querschnitt aufweist.
